# EUROPÄISCHE PATENTANMELDUNG

(11) **EP 3 882 371 A2**
(43) Veröffentlichungstag der Anmeldung: **22.09.2021**
(21) Anmeldenummer: 21162052.1
(22) Anmeldetag: 11.03.2021
(51) Int. Cl.: C23C 14/16, C22C 21/00, C23C 14/34, C23C 14/35, C23C 30/00

(54) **KORROSIONSSCHÜTZENDE BESCHICHTUNG UND MIT EINER KORROSIONSSCHÜTZENDEN BESCHICHTUNG BESCHICHTETER GEGENSTAND INSBESONDERE FÜR DIE VERWENDUNG AN EINEM FLUGZEUG**

(30) Priorität: 17.03.2020 DE 102020107278
(71) Anmelder: Airbus Operations GmbH, 21129 Hamburg (DE); Airbus Defence and Space GmbH, 82024 Taufkirchen (DE); Helmholtz-Zentrum Geesthacht Zentrum für Material- und Küstenforschung GmbH, 21502 Geesthacht (DE)
(72) Erfinder: KRÖGER-KALLIES, Bettina, 21129 Hamburg (DE); DOERR, Tillmann, 21129 Hamburg (DE); ROHR, Oliver, 82024 Taufkirchen (DE); BLAWERT, Carsten, 21502 Geesthacht (DE); GEHRIG, Florian, 21129 Hamburg (DE); DEL ROSARIO SILVA CAMPOS, Maria, 21502 Geesthacht (DE); STÖRMER, Michael, 21502 Geesthacht (DE); ZHELUDKEVICH, Mikhail, 21502 Geesthacht (DE)
(74) Vertreter: LKGLOBAL Lorenz & Kopf PartG mbB Patentanwälte

(57) **Zusammenfassung**

Die Erfindung betrifft eine korrosionsschützende Beschichtung und einen mit einer korrosionsschützenden Beschichtung beschichteten Gegenstand insbesondere für die Verwendung an einem Flugzeug, ein Verfahren zum Herstellen eines beschichteten Gegenstands sowie ein Fahrzeug und insbesondere Flugzeug umfassend eine derartige korrosionsschützende Beschichtung oder mindestens einen derartigen beschichteten Gegenstand. Es wird eine korrosionsschützende Beschichtung gezeigt, umfassend eine Aluminiumlegierung, die 0,03-0,5 Gewichts-% Zinn umfasst. Weiterhin wird ein beschichteter Gegenstand gezeigt, wobei der Gegenstand zumindest teilweise aus einem Material hergestellt ist, und zumindest teilweise mit der korrosionsschützenden Beschichtung, umfassend eine Aluminiumlegierung, die 0,03-0,5 Gewichts-% Zinn umfasst, beschichtet ist. Weiterhin wird ein Verfahren zur Herstellung einer solchen korrosionsschützenden Beschichtung gezeigt.

## Beschreibung

### TECHNISCHES GEBIET

Die Erfindung betrifft eine korrosionsschützende Beschichtung und einen mit einer korrosionsschützenden Beschichtung beschichteten Gegenstand insbesondere für die Verwendung an einem Flugzeug, ein Verfahren zum Herstellen eines beschichteten Gegenstands sowie ein Fahrzeug und insbesondere Flugzeug umfassend eine derartige korrosionsschützende Beschichtung oder mindestens einen derartigen beschichteten Gegenstand.

### HINTERGRUND DER ERFINDUNG

Cadmium-Schichten werden in der Luftfahrt seit Jahrzehnten für verschiedenste Anwendungen und Bauteile insbesondere aus Stahl eingesetzt, da Cadmium eine gute Korrosionsbeständigkeit und opferanodische Schutzwirkung gegenüber verschiedenen Substraten, insbesondere eisenhaltigen Substraten, wie beispielsweise Stahl aufweist und zudem eine galvanische Kompatibilität zu einem aus einer Aluminiumlegierung gefertigten Flugzeugrumpf, eine hohe elektrische Leitfähigkeit, gute Schweiß- und Lötbarkeit sowie zusätzlich eine gewisse Schmierwirkung hat. Typischerweise könnten Verbindungselemente, Strukturteile oder elektrische Teile wie Stecker oder ähnliches eine Cadmiumbeschichtung aufweisen. Besonders häufig wird dabei eine elektrolytisch abgeschiedene Cadmiumschicht mit nachfolgender Cr(VI)-basierter Passivierung verwendet. Allerdings kann die Verwendung von Cadmium durch zukünftige Vorschriften eingeschränkt werden.

Derzeit ist keine Beschichtung bekannt, die die guten technischen Eigenschaften von Cadmium für einen flugzeugweiten Einsatz erreicht. Generell ist die opferanodische Schutzwirkung von Cadmium insbesondere gegenüber eisenhaltigen Substraten, wie beispielsweise Stahl, eine grundlegende Funktion, die auch von alternativen Beschichtungen erfüllt werden muss. In den vergangenen Jahren wurden einige Beschichtungen für den Cadmiumersatz untersucht, die insbesondere Zink und Aluminium basierte Legierungen oder metallgefüllte organische oder anorganische Beschichtungen, wie beispielsweise Zinklamellenbeschichtungen oder aluminiumpigmentierte Beschichtungen, umfassen. Dabei haben sich elektrolytisch abgeschiedene Zink-Nickel (ZnNi)-Schichten mit einem Nickelgehalt von etwa 10 % bis 15 % als tendenziell am Geeignetsten herausgestellt. Mit ZnNi-Schichten können jedoch nicht sämtliche luftfahrttechnischen Anwendungen abgedeckt werden. Weiterhin ist es günstig, die Verwendung von Nickelverbindungen möglichst einzuschränken.

Es ist bekannt, mittels Ionen-Dampf-Abscheideverfahren (IVD, "Ion Vapor Deposition") eine Aluminiumbeschichtung auf Bauteilen anzubringen, um Cadmium zu ersetzen. Allerdings leidet diese Beschichtung unter einer starken Selbstpassivierung des Aluminiums, so dass nicht alle relevanten Bauteile durch IVD-Aluminium beschichtet werden können. PVD-Prozesse und insbesondere Magnetron-Sputtern sind bekannt, um Aluminiumlegierungen auf Oberflächen anzubringen. Das kolumnare Wachstum der Schichten kann sich jedoch nachteilig auswirken, da es zu einer hohen Porosität und damit zu erhöhtem Verschleiß führt. Elektrolytische Abscheidungsverfahren sind ebenso bekannt.

### ZUSAMMENFASSUNG DER ERFINDUNG

Es ist eine Aufgabe der Erfindung, eine korrosionsschützende Beschichtung für Gegenstände, insbesondere für metallische Gegenstände, beispielsweise einen eisenhaltigen Gegenstand oder einen Gegenstand aus einem Stahl, vorzuschlagen, die zum Korrosionsschutz als Opferanode wirkt, einen besonders geringen Verschleiß aufweist, kostengünstig und in geringer Schichtdicke aufbringbar und zudem frei von Cadmium ist. Weiterhin ist es Aufgabe der Erfindung einen mit der korrosionsschützenden Beschichtung beschichteten Gegenstand sowie ein Verfahren zur Herstellung eines solchen mit der korrosionsschützenden Beschichtung beschichteten Gegenstands bereitzustellen.

Diese Aufgabe wird gelöst durch die korrosionsschützende Beschichtung mit den Merkmalen des unabhängigen Anspruchs 1 sowie durch den beschichteten Gegenstand mit den Merkmalen des unabhängigen Anspruchs 6 und das Verfahren mit den Merkmalen des unabhängigen Anspruchs 12. Vorteilhafte Ausführungsformen und Weiterbildungen sind den Unteransprüchen und der nachfolgenden Beschreibung zu entnehmen.

### KURZBESCHREIBUNG DER ABBILDUNGEN

- Abb. 1:: Schaubild zur Veranschaulichung des gemessenen galvanischen Stroms für verschiedene unbeschichtete und beschichtete Substrate nach drei Stunden Eintauchen in Harrisons Lösung (0,05 % NaCl + 0,35% (NH₄)₂SO₄).

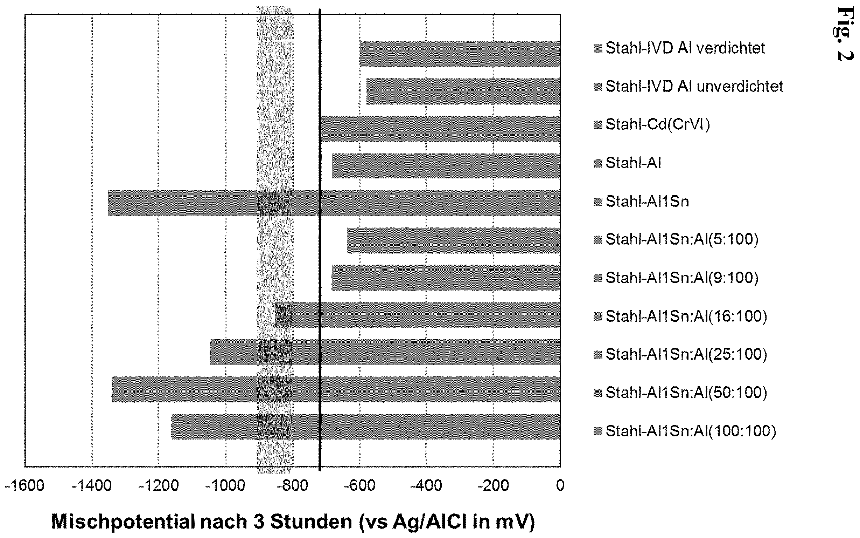

- Abb. 2:: Schaubild zur Veranschaulichung des gemessenen Mischpotentials für verschiedene unbeschichtete und beschichtete Substrate nach drei Stunden Eintauchen in Harrisons Lösung (0,05 % NaCl + 0,35% (NH₄)₂SO₄).

### DETAILLIERTE BESCHREIBUNG DER ERFINDUNG

Es wird eine korrosionsschützende Beschichtung vorgeschlagen, umfassend eine Aluminiumlegierung, die 0,03-0,5 Gewichts-% Zinn (Sn) umfasst. In einer bevorzugten Ausführungsform besteht die korrosionsschützende Beschichtung aus der hierin und in den Ansprüchen beschriebenen Aluminiumlegierung.

Die Verwendung einer Aluminiumlegierung in der korrosionsschützenden Beschichtung ist günstig, da Aluminium ein niedriges Elektrodenpotential aufweist. Beispielsweise ist das Elektrodenpotential des Aluminiums in der Regel niedriger als das von eisenhaltigen Materialien, wie beispielsweise Stahl, die potentielle und bevorzugte mit der korrosionsschützenden Beschichtung beschichtbare Substrate darstellen. Die Beschichtung wirkt als Opferanode und schützt das damit beschichtete Substrat bzw. den damit beschichteten Gegenstand kathodisch. Die Beschichtung löst sich folglich nach und nach auf und schützt dadurch das darunter liegende Substrat, beispielsweise ein eisenhaltiges Material wie beispielsweise Stahl. Durch geeignete Zusammensetzung der Aluminiumlegierung kann der Auflösungsgrad der Aluminiumlegierung minimiert werden, so dass die korrosionsschützende Wirkung der korrosionsschützenden Beschichtung hinreichend lange anhält.

Eine reine Aluminiumbeschichtung neigt allerdings zur Passivierung durch Bildung einer Aluminiumoxidschicht an der Oberfläche der Aluminiumbeschichtung. Die Aluminiumoxidschicht schützt das darunterliegende Aluminium, so dass das an sich wegen seines niedrigen Elektrodenpotential unedle Aluminium vor Auflösung geschützt ist. Um eine zu starke Passivierung des Aluminiums zu unterbinden, bzw. die Passivierung des Aluminiums zumindest soweit zurückzudrängen, dass das Aluminium zum kathodischen Schutz des damit beschichteten Gegenstandes zur Verfügung steht, umfasst die Aluminiumlegierung in der korrosionsschützenden Beschichtung gemäß der Erfindung als weiteren Legierungsbestandteil Zinn (Sn). Gleichzeitig ist aber auch eine gewisse Passivierung der Aluminiumlegierung durchaus erwünscht, da diese einen zu schnellen Verbrauch der korrosionsschützenden Beschichtung verhindert und so zu einer längeren Haltbarkeit der korrosionsschützenden Beschichtung beiträgt.

Die Aluminiumlegierung in der korrosionsschützenden Beschichtung gemäß der Erfindung umfasst 0,03-0,5 Gewichts-% Zinn (Sn), bezogen auf das Gesamtgewicht der Aluminiumlegierung. Bevorzugt umfasst die Aluminiumlegierung in der korrosionsschützenden Beschichtung gemäß der Erfindung 0,0,45-0,35 Gewichts-% Zinn, wie beispielsweise 0,1-0,3 Gewichts-% Zinn oder 0,1-0,2 Gewichts-% Zinn, jeweils bezogen auf das Gesamtgewicht der Aluminiumlegierung. Noch bevorzugter umfasst die Aluminiumlegierung in der korrosionsschützenden Beschichtung gemäß der Erfindung 0,13-0,19 Gewichts-% Zinn, wie beispielsweise 0,13-0,17 Gewichts-% Zinn oder 0,13-0,16 Gewichts-% Zinn, jeweils bezogen auf das Gesamtgewicht der Aluminiumlegierung. Besonders bevorzugt umfasst die Aluminiumlegierung in der korrosionsschützenden Beschichtung gemäß der Erfindung 0,13-0,15 Gewichts-% Zinn, bezogen auf das Gesamtgewicht der Aluminiumlegierung.

Überraschend hat sich herausgestellt, dass die Verwendung von Zinn bereits in der angegebenen Menge in der Aluminiumlegierung dazu führt, dass dadurch eine vollständige Passivierung des Aluminiums unterbunden bzw. hinreichend stark zurückgedrängt wird. Gleichzeitig hat sich ebenfalls überraschend herausgestellt, dass diese Menge von Zinn aber auch gewährleistet, dass die Korrosion der Aluminiumbeschichtung nicht zu schnell erfolgt und daher die korrosionsschützende Wirkung der Aluminiumlegierung der Erfindung auf einem Substrat, beispielsweise einem eisenhaltigen Substrat wie beispielsweise Stahl, hinreichend lange anhält. Diese Eigenschaften und insbesondere das Unterbinden der Passivierung kann dabei unter bei einer Verwendung an einem Luftfahrzeug auftretenden Bedingungen, insbesondere unter Luftfahrtbedingungen, gewährleistet sein, d.h. in einem Absolutdruckbereich von etwa 0,25 bis etwa 1 bar sowie für einen Temperaturbereich von etwa -50°C bis etwa 60°C.

Die Aluminiumlegierung in der korrosionsschützenden Beschichtung gemäß der Erfindung kann weitere Legierungsbestandteile umfassen. Diese weiteren

Legierungsbestandteile sind bevorzugt ausgewählt aus Mangan (Mn), Silizium (Si), Zink (Zn), Gallium (Ga), Magnesium (Mg), Chrom (Cr), Eisen (Fe), Titan (Ti), Indium (In), Bismut (Bi), Selen (Se), Kupfer (Cu), Zirkonium (Zr), Antimon (Sb), Kobalt (Co) und Kombinationen davon. Diese Elemente können zum Einstellen eines resultierenden elektrochemischen Potentials der Aluminiumlegierung genutzt werden, die dem von Cadmium ähneln, da jedes dieser Elemente prinzipiell geeignet ist, das elektrochemische Potential von reinem Aluminium zu noch stärker elektronegativen Werten zu verschieben. Zudem lässt sich durch Zugabe dieser weiteren Legierungsbestandteile auch eine einheitlichere korrosionsschützende Beschichtung ausbilden, was beispielsweise zu einem gleichmäßigeren Verbrauch der Opferanode führen kann. Zu diesem Zweck können insbesondere Mangan (Mn), Zink (Zn) und Magnesium (Mg) vorteilhaft verwendet werden. Aluminiumlegierungen mit einem Mangananteil zeichnen sich durch eine besonders hohe Korrosionsbeständigkeit aus. Silizium kann zur Reduktion des Schmelzpunkts von Aluminiumlegierungen genutzt werden und kann damit den Vorgang des Beschichtens eines Substrats mit der Aluminiumlegierung der Erfindung verbessern. Zink verbessert allgemein die Korrosionsschutzeigenschaften einer Aluminiumlegierung. Besonders vorteilhaft und bevorzugt ist die Verwendung von Zink (Zn) als zusätzlichen Legierungsbestandteil der beschriebenen Aluminiumlegierung.

Die Aluminiumlegierung in der korrosionsschützenden Beschichtung gemäß der Erfindung kann die oben genannten zusätzlichen Legierungsbestandteile Mangan (Mn), Silizium (Si), Gallium (Ga), Magnesium (Mg), Chrom (Cr), Eisen (Fe), Titan (Ti), Indium (In), Bismut (Bi), Selen (Se), Kupfer (Cu), Zirkonium (Zr), Antimon (Sb), Kobalt (Co) beispielsweise jeweils in einer Menge von bis zu 2 Gewichts-%, bevorzugt 1 Gewichts-%, noch bevorzugter in einer Menge von 0,5 Gewichts-%, beispielsweise in einer Menge von 0,01-0,3 Gewichts-% oder von 0,05 bis 0,2 Gewichts-%, jeweils bezogen auf das Gesamtgewicht der Aluminiumlegierung, umfassen.

Alternativ oder zusätzlich zu den zusätzlichen Legierungsbestandteilen Mangan (Mn), Silizium (Si), Gallium (Ga), Magnesium (Mg), Chrom (Cr), Eisen (Fe), Titan (Ti), Indium (In), Bismut (Bi), Selen (Se), Kupfer (Cu), Zirkonium (Zr), Antimon (Sb), Kobalt (Co) in den hierin beschriebenen Mengen kann die Aluminiumlegierung in der korrosionsschützenden Beschichtung gemäß der Erfindung den oben genannten zusätzlichen Legierungsbestandteil Zink (Zn) in einer Menge von bis zu 10 Gew.-%, bevorzugt bis zu 7 Gew.-%, beispielsweise von 1 bis 5 Gewichts-%, bevorzugt von 2 bis 4 Gew.-%, jeweils bezogen auf das Gesamtgewicht der Aluminiumlegierung, umfassen.

In einer bevorzugten Ausführungsform umfasst die Aluminiumlegierung in der korrosionsschützenden Beschichtung gemäß der Erfindung als zusätzlichen Legierungsbestandteil nur Zink (Zn) in einer Menge von bis zu 10 Gew.-%, bevorzugt bis zu 7 Gew.-%, beispielsweise von 1 bis 5 Gewichts-%, bevorzugt von 2 bis 4 Gew.-%, jeweils bezogen auf das Gesamtgewicht der Aluminiumlegierung.

Die Gesamtmenge an den zusätzlichen Legierungsbestandteilen in der Aluminiumlegierung in der korrosionsschützenden Beschichtung gemäß der Erfindung kann bis zu 20 Gew.-% betragen, bevorzugt bis zu 10 Gew.-%, noch bevorzugter bis zu 7 Gew.-%, beispielsweise von 1 bis 5 Gewichts-%, bevorzugt von 2 bis 4 Gew.-%, jeweils bezogen auf das Gesamtgewicht der Aluminiumlegierung.

Die Aluminiumlegierung in der korrosionsschützenden Beschichtung gemäß der Erfindung umfasst als Hauptbestandteil bzw. als Rest Aluminium und unvermeidbare Verunreinigungen. Unvermeidbare Verunreinigungen können beispielsweise in einer Gesamtmenge von bis zu 0,5 Gew.-%, beispielsweise bis zu 0,1 oder bis zu 0,05 Gew.-% oder bis zu 0,01 Gew.-% oder bevorzugt bis zu 0,001 Gew.-%, jeweils bezogen auf das Gesamtgewicht der Aluminiumlegierung, in der Aluminiumlegierung enthalten sein.

Die Aluminiumlegierung in der korrosionsschützenden Beschichtung gemäß der Erfindung umfasst bevorzugt kein Cadmium und ist besonders bevorzugt völlig cadmiumfrei, d.h. Cadmium ist auch nicht als unvermeidbare Verunreinigung enthalten.

In einer Ausführungsform besteht die Aluminiumlegierung in der korrosionsschützenden Beschichtung gemäß der Erfindung aus Zinn (Sn) in den hierin beschriebenen Mengen, optional weiteren Legierungsbestandteilen ausgewählt aus Mangan (Mn), Silizium (Si), Zink (Zn), Gallium (Ga), Magnesium (Mg), Chrom (Cr), Eisen (Fe), Titan (Ti), Indium (In), Bismut (Bi), Selen (Se), Kupfer (Cu), Zirkonium (Zr), Antimon (Sb), Kobalt (Co) und Kombinationen davon in den hierin beschriebenen Mengen und als Hauptbestandteil bzw. als Rest Aluminium und unvermeidbaren Verunreinigungen in den hierin beschriebenen Mengen.
In einer Ausführungsform besteht die Aluminiumlegierung in der korrosionsschützenden Beschichtung gemäß der Erfindung aus Zinn (Sn) in den hierin beschriebenen Mengen, optional weiteren Legierungsbestandteilen ausgewählt aus Mangan (Mn), Silizium (Si), Zink (Zn), Magnesium (Mg) und Kombinationen davon in den hierin beschriebenen Mengen und als Hauptbestandteil bzw. als Rest Aluminium und unvermeidbaren Verunreinigungen in den hierin beschriebenen Mengen.

In einer Ausführungsform besteht die Aluminiumlegierung in der korrosionsschützenden Beschichtung gemäß der Erfindung aus Zinn (Sn) und Zink (Zn) jeweils in den hierin beschriebenen Mengen, optional weiteren Legierungsbestandteilen ausgewählt aus Mangan (Mn), Silizium (Si), Magnesium (Mg) und Kombinationen davon in den hierin beschriebenen Mengen und als Hauptbestandteil bzw. als Rest Aluminium und unvermeidbaren Verunreinigungen in den hierin beschriebenen Mengen.

In einer Ausführungsform besteht die Aluminiumlegierung in der korrosionsschützenden Beschichtung gemäß der Erfindung aus Zinn (Sn) in den hierin beschriebenen Mengen, optional Zink (Zn) als weiteren Legierungsbestandteil in den hierin beschriebenen Mengen und als Hauptbestandteil bzw. als Rest Aluminium und unvermeidbaren Verunreinigungen in den hierin beschriebenen Mengen.

In einer weiter bevorzugten Ausführungsform besteht die Aluminiumlegierung aus 0,03-0,5 Gewichts-% Zinn , bevorzugt 0,045-0,35 Gewichts-% Zinn, wie beispielsweise 0,1-0,3 Gewichts-% Zinn oder 0,1-0,2 Gewichts-% Zinn, jeweils bezogen auf das Gesamtgewicht der Aluminiumlegierung, und dem Rest Aluminium (Al) sowie unvermeidbaren Verunreinigungen. Die unvermeidbaren Verunreinigungen können in der Aluminiumlegierung in den hierein beschriebenen Mengen enthalten sein.

In einer besonders bevorzugten Ausführungsform besteht die Aluminiumlegierung aus 0,13-0,19 Gewichts-% Zinn, wie beispielsweise 0,13-0,15 Gewichts-% Zinn, jeweils bezogen auf das Gesamtgewicht der Aluminiumlegierung, und dem Rest Aluminium (Al) sowie unvermeidbaren Verunreinigungen. Die unvermeidbaren Verunreinigungen können in der Aluminiumlegierung in den hierein beschriebenen Mengen enthalten sein.

Die Aluminiumlegierung in der korrosionsschützenden Beschichtung gemäß der Erfindung hat den Vorteil, dass sie keine zu starke Passivierung zeigt, die für die Verwendung als Opferanode nachteilig ist, und zusätzlich ihre elektrochemischen Eigenschaften denen der derzeit gebräuchlichen cadmiumhaltigen Schutzschichten ähnelt.

Die korrosionsschützende Beschichtung der Erfindung weist bevorzugt eine Dicke von 0,1 bis 100 µm, bevorzugter von 1 bis 50 µm, noch bevorzugter von 5 bis 25 µm und besonders bevorzugt von 7 bis 20 µm auf. Beispielsweise kann die korrosionsschützende Beschichtung der Erfindung eine Dicke von entweder 10 bis 20 µm oder von 7 bis 10 µm aufweisen. Eine solche Dicke der korrosionsschützenden Beschichtung hat sich als vorteilhaft herausgestellt, da dadurch zum einen der Gesamtbedarf an korrosionsschützender Beschichtung gering gehalten werden kann, zum anderen eine gute und hinreichend lange Korrosionsschutzwirkung erzielt werden kann und zusätzlich die korrosionsschützende Beschichtung sich nicht nachteilig auf das Gesamtgewicht des beschichteten Gegenstandes auswirkt.

Die korrosionsschützende Beschichtung der Erfindung ist weiterhin bevorzugt dazu geeignet, mittels eines Vakuumabscheideverfahrens auf ein Substrat, beispielsweise einen eisenhaltigen Gegenstand wie beispielsweise einen Stahl, aufgetragen zu werden. Beispielsweise ist die korrosionsschützende Beschichtung der Erfindung geeignet, mithilfe von Sputtertechniken oder einem IVD (ion vapour deposition)-Verfahren aufgetragen zu werden. Der Vorteil dieser Auftragungstechniken ist, dass dadurch eine besonders gleichmäßige und homogene und zudem sehr dünne Auftragung von Schichten erreicht werden kann. Sowohl Sputtertechniken als auch IVD-Verfahren sind dem Fachmann wohlbekannt.

Weiterhin wird ein beschichteter Gegenstand vorgeschlagen, wobei der Gegenstand zumindest teilweise aus einem Material hergestellt ist, und zumindest teilweise mit der korrosionsschützenden Beschichtung wie hierin und in den Ansprüchen beschrieben beschichtet ist. Der Gegenstand wird hierin auch gleichbedeutend als Substrat bezeichnet. Bevorzugt ist der Gegenstand aus einem einzigen Material hergestellt und/oder vollständig mit der korrosionsschützenden Beschichtung der Erfindung beschichtet. Besonders bevorzugt ist der Gegenstand aus einem einzigen Material hergestellt und vollständig mit der korrosionsschützenden Beschichtung der Erfindung beschichtet.

Das mit der korrosionsschützenden Beschichtung gemäß der Erfindung beschichtbare Material ist nicht beschränkt und kann alle möglichen Metalle oder Legierungen umfassen, wie beispielsweise Eisen und Eisenlegierungen, Stähle, Titan und Titanlegierungen, Kupfer und Kupferlegierungen, Nickel und Nickellegierungen, Aluminium und Aluminiumlegierungen, etc. umfassen.

In einer bevorzugten Ausführungsform gemäß der Erfindung ist der Gegenstand, der zumindest teilweise, bevorzugt vollständig, mit der korrosionsschützenden Beschichtung der Erfindung beschichtet ist, aus einem Material hergestellt, das eisenhaltig ist. Beispielsweise kann das Material Eisen, wie beispielsweise Gusseisen oder Schmiedeeisen, oder jede bekannte eisenhaltige Legierung, wie beispielsweise für die Luft- und Raumfahrt qualifizierte eisenhaltige Legierungen sein.

In einer besonders bevorzugten Ausführungsform gemäß der Erfindung ist das eisenhaltige Material, aus dem der Gegenstand, der zumindest teilweise, bevorzugt vollständig, mit der korrosionsschützenden Beschichtung der Erfindung beschichtet ist, hergestellt ist, Stahl. Es kommen beispielsweise alle kommerziell erhältlichen Stähle in Frage. Bevorzugt sind solche Stähle, die für die Verwendung in der Luft- und Raumfahrt qualifiziert sind, beispielsweise die Stähle aus der Werkstoffgruppe "Sonderstähle Luft- und Raumfahrt" oder die dem Fachmann bekannten Legierungen mit den Bezeichnungen 1.7734, 1.6604, 1.6944, 1.7214, 1.1174, 35NCD16, 15-5PH, 17-4PH, 17-7PH, 13-8PH, 1.4544, 1.4944, 1.4044, 1.4304, 1.4541, 1.4544. Besonders bevorzugt ist dabei der Stahl 1.7734. Der Stahl 1.7734 enthält 0,12-0,18 Gew.-% Kohlenstoff (C), 0,8-1,1 Gew.-% Mangan (Mn), ≤ 0,20 Gew.-% Silicium (Si), 0,02 Gew.-% Phosphor (P), 0,015 Gew.-% Schwefel (S), 1,25-1,5 Gew.-% Chrom (Cr), 0,8-1,0 Gew.-% Molybdän (Mo) und 0,20-0,30 Gew.-% Vanadium (V).

Die korrosionsschützende Beschichtung gemäß der Erfindung auf dem beschichteten Gegenstand gemäß der Erfindung kann eine Dicke von 0,1 bis 100 µm, bevorzugt von 1 bis 50 µm, bevorzugter von 5 bis 25 µm und besonders bevorzugt von 7 bis 20 µm, wie beispielsweise entweder von 10 bis 20 µm oder von 7 bis 10 µm, aufweisen.

In einer bevorzugten Ausführungsform ist die korrosionsschützende Beschichtung der Erfindung auf den beschichteten Gegenstand der Erfindung mithilfe einer Sputtertechnik oder einem IVD (ion vapour deposition)-Verfahren aufgetragen.

Ein weiterer Gegenstand der Erfindung ist ein Verfahren zum Herstellen eines beschichteten Gegenstands wie hierin und in den Ansprüchen beschrieben.
Das erfindungsgemäße Verfahren umfasst die Schritte Bereitstellen eines Gegenstands, und zumindest teilweises, bevorzugt vollständiges, Beschichten des Substrats mit der korrosionsschützenden Beschichtung wie hierin und in den Ansprüchen beschrieben und bevorzugt mit der Aluminiumlegierung wie hierin und in den Ansprüchen beschrieben.

In einer bevorzugten Ausführungsform des Verfahrens gemäß der Erfindung kann das Beschichten des Substrats, bevorzugt eines Gegenstands aus einer eisenhaltigen Legierung, wie beispielsweise Stahl, mit der korrosionsschützenden Beschichtung mithilfe von Sputtertechniken beispielweise unter Verwendung eines Magnetrons erfolgen, bevorzugt mithilfe einer Co-Sputtertechnik. Diese Auftragungstechniken sind dem Fachmann wohlbekannt und bedürfen daher keiner näheren Erläuterung. Dem Fachmann ist ebenso bekannt, dass bei der sogenannten Co-Sputtertechnik das Substrat unter Verwendung von zwei Sputtertargets aus zwei verschiedenen Legierungen oder auch Reinstoffen oder Reinmetallen in bestimmten Massenverhältnissen gleichzeitig besputtert wird. Dies ermöglicht das Auftragen von definierten Zusammensetzungen bzw. Legierungen unter Verwendung von zwei verschiedenen Sputtertargets. Der Vorteil dieser Technik ist, dass dadurch die Verwendung beispielsweise von kommerziell gut erhältlichen Sputtertargets ermöglicht wird.

Ein weiterer Gegenstand der Erfindung ist die Verwendung einer Aluminiumlegierung, die 0,03 bis 0,5 Gewichts-% Zinn, bevorzugt 0,1-0,35 Gewichts-% Zinn, bevorzugter 0,13-0,19 Gewichts-% Zinn und besonders bevorzugt 0,13-0,15 Gewichts-% Zinn umfasst, zum Herstellen einer Korrosionsschutzbeschichtung für einen eisenhaltigen Gegenstand. Bevorzugt in der Verwendung gemäß der Erfindung ist dabei die hierin und in den Ansprüchen beschriebene Aluminiumlegierung. Weiterhin bevorzugt ist, dass der eisenhaltige Gegenstand ein Stahl ist. Der eisenhaltige Gegenstand kann ein eisenhaltiger Gegenstand wie hierin beschrieben sein.

Ein weiterer Gegenstand der Erfindung ist ein Fahrzeug, bevorzugt Luftfahrzeug, umfassend eine korrosionsschützende Beschichtung wie hierin und den Ansprüchen beschrieben oder einen beschichteten Gegenstand wie hierin oder in den Ansprüchen beschrieben.

Insbesondere für Luftfahrtanwendungen ist die galvanische Kompatibilität etwa beschichteter Verbindungselemente gegenüber dem Werkstoff der zu verbindenden Komponenten eine wichtige Voraussetzung. Der beschichtete Gegenstand kann etwa ein Verbindungselement sein, welches zur Befestigung an einem eine Aluminiumlegierung aufweisenden Bauteil genutzt wird. Dieses Bauteil kann etwa ein Teil eines Flugzeugrumpfs aus einer Aluminiumlegierung sein.

Bevorzugt ist der mit der korrosionsschützenden Beschichtung beschichtete Gegenstand, bzw. das Substrat, ein eisenhaltiges Material wie beispielsweise Stahl. Durch die kadmiumfreie korrosionsschützende Beschichtung der Erfindung können insbesondere an einem Luftfahrzeug unterschiedliche Bauteile mit einem Korrosionsschutz versehen werden. Diese beinhalten Befestigungselemente, Gabelköpfe, Buchsen, Unterleg- und Distanzscheiben und zahlreiche weitere Elemente.

Ergänzend sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können.

### BEISPIELE

Weitere Merkmale, Vorteile und Anwendungsmöglichkeiten der vorliegenden Erfindung ergeben sich aus den nachfolgenden Beispielen. Diese Beispiele sollen aber den Umfang der Erfindung nicht beschränken, sondern dienen lediglich der besseren Illustration von einzelnen Gegenständen und Vorteilen der Erfindung.

### Beispiel 1:

Silizium-Wafer wurden mit verschiedenen Aluminiumlegierungen durch Magnetron-Sputtern beschichtet. Dabei kam eine Co-Sputtertechnik unter Verwendung von Reinaluminium und Al1Sn als Sputtertargets zur Verwendung. Dies bedeutet, dass das Substrat mit zwei Targets aus Reinaluminium und Al1Sn in verschiedenen Massenverhältnissen gleichzeitig besputtert wurde.

Aluminiumlegierungen wurden als reines Al1Sn sowie in den Leistungsverhältnissen (bzw. Sputterverhältnissen) der Sputtertargets Al1Sn-Aluminium (100:100), AllSn-Aluminium (50:100), Al1Sn-Aluminium (Al) (25:100), Al1Sn-Aluminium (16:100), Al1Sn-Aluminium (9:100), Al1Sn-Aluminium (5:100) aufgetragen. Beispielsweise bedeutet Al1Sn-Al (16:100), dass eine Al1Sn-Legierung und Aluminium (Al) in einem Sputterverhältnis von 16 zu 100 durch Co-Sputtern aufgetragen wurden. Dies entspricht einer theoretisch in den Schichten enthaltenen Menge (in Gewichts-%) an Zinn (Sn) von 0,5 Gew.-% Sn für Al1Sn-Al (100:100), von 0,33 Gew.-% Sn für Al1Sn-Al (50:100), von 0,20 Gew.-% Sn für Al1Sn-Al (25:100), von 0,138 Gew.-% Sn für Al1Sn-Al (16:100), von 0,083 Gew.-% Sn für Al1Sn-Al (9:100) und von 0,048 Gew.-% Sn für AllSn-Al (5:100).

Es wurde der galvanische Strom zwischen Stahl (1.7734.5) und den verschiedenen Beschichtungen aus den Aluminiumlegierungen auf den Silizium-Wafern nach drei Stunden Eintauchen in Harrisons Lösung (0,05 % NaCl + 0,35% (NH₄)₂SO₄) gemessen. Harrisons Lösung stellt eine typische in Korrosionsschutztests verwendete Lösung dar. Die Stahloberfläche betrug 0,01 cm² und die Oberfläche der Beschichtungen aus Aluminiumlegierungen 0,5 cm². Die Aluminiumlegierungen auf Silizium-Wafern wurden wie in Beispiel 1 hergestellt. Zusätzlich wurde eine Probe mit einer üblichen Cadmium-basierten Korrosionsschutzschicht (Cd + Chromatierung) sowie Proben mit Schichten nur aus Aluminium (Al) untersucht.

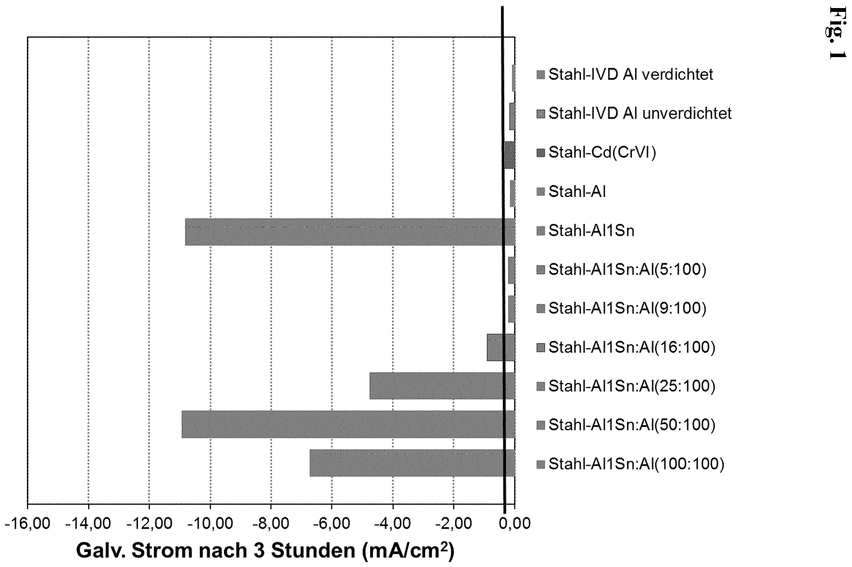

Abbildung 1 (Abb. 1) zeigt den für verschiedene unbeschichtete und beschichtete Substrate gemessenen galvanischen Strom, der ein Maß für die galvanische Korrosion ist. Al1Sn und Al1Sn-Al (50:100) Beschichtungen zeigen ähnliche und recht hohe galvanische Korrosion. Dies kann zu Defekten oder einer aktiveren Auflösung bereits nach kürzerer Zeit führen. Niedrigere Ströme weisen Al1Sn-Al (100:100) und Al1Sn-Al (25:100) auf. Ähnliche Ströme weisen Cd(CrVI), Al, Al1Sn-Al (5:100) und Al1Sn-Al (9:100) auf. Al1Sn-Al (16:100) weist einen leicht erhöhten Strom verglichen zu Cd(Cr(VI) auf. Beim IVD Al, verdichtet durch Strahlen mit Glaskugeln bzw. unverdichtet, ist der galvanische Strom sehr gering. Die Stärke des galvanischen Stroms ist ein Indikator dafür, wie schnell eine entsprechende Opferanode aufgelöst, d.h. verbraucht, wird. Prinzipiell sind für viele Anwendungen solche Ströme bevorzugter, die sich im Bereich des für die heutzutage üblicherweise verwendeten cadmiumhaltigen Korrosionsschutzschicht gemessenen Stroms befinden.

### Beispiel 2:

Es wurde das Mischpotential zwischen Stahl (1.7734.5) und verschiedenen Beschichtungen aus Aluminiumlegierungen auf Silizium-Wafern nach drei Stunden Eintauchen in Harrisons Lösung (0,05 % NaCl + 0,35% (NH₄)₂SO₄) gemessen. Harrisons Lösung stellt eine typische in Korrosionsschutztests verwendete Lösung dar. Als Referenzelektrode wurde eine Ag/AgCl-Elektrode verwendet. Die Stahl oberfläche betrug 0,01 cm² und die Oberfläche der Beschichtungen aus Aluminiumlegierungen 0,5 cm². Die Aluminiumlegierungen auf Silizium-Wafern wurden wie in Beispiel 1 hergestellt. Zusätzlich wurde eine Probe mit einer üblichen Cadmium-basierten Korrosionsschutzschicht (Cd + Chromatierung) sowie Proben mit Schichten nur aus Aluminium (Al) untersucht.

Um Stahl in Harrisons Lösung effektiv vor Korrosion zu schützen bedarf es eines Potentials mit einem Wert von um die -730 mV Ag/AgCl, d.h. den für eine übliche cadmiumhaltige Korrosionsschutzbeschichtung (Cd(CrVI)) gemessenen Wert, oder mehr. Für manche Anwendungen, beispielsweise zum effektiven Korrosionsschutz in einem Medium mit einer höheren Chloridkonzentration, beispielsweise einer Konzentration, die der Chloridkonzentration in Meerwasser entspricht, bedarf es eines Mischpotentialwertes von ca. -800 bis zu -900 mV. Ein wesentlich höheres Mischpotential kann zu einem in manchen Anwendungen weniger erwünschten unnötigen Verbrauch der Opferanode führen. Das Potential der Beschichtung Al1 Sn-Al (16:100) liegt knapp über -800 mV und weist somit ein Mischpotential innerhalb des oben als besonders wünschenswert genannten Bereichs auf.

## Patentansprüche

1. Korrosionsschützende Beschichtung, umfassend eine Aluminiumlegierung, die 0,03-0,5 Gewichts-% Zinn umfasst.

2. Korrosionsschützende Beschichtung nach Anspruch 1, wobei die Aluminiumlegierung 0,045-0,35 Gewichts-% Zinn, bevorzugt 0,1-0,3 Gewichts-% Zinn, bevorzugter 0,13-0,19 Gewichts-% Zinn und besonders bevorzugt 0,13-0,15 Gewichts-% Zinn umfasst.

3. Korrosionsschützende Beschichtung nach Anspruch 1, wobei die Aluminiumlegierung aus 0,03-0,5 Gewichts-% Zinn und dem Rest Aluminium sowie unvermeidbaren Verunreinigungen besteht.

4. Korrosionsschützende Beschichtung nach Anspruch 1, wobei die Aluminiumlegierung aus 0,045-0,35 Gewichts-% Zinn, bevorzugt 0,1-0,3 Gew.-% Zinn, bevorzugter 0,13-0,19 Gewichts-% Zinn und besonders bevorzugt 0,13-0,15 Gewichts-% Zinn und dem Rest Aluminium sowie unvermeidbaren Verunreinigungen besteht.

5. Korrosionsschützende Beschichtung nach einem der Ansprüche 1-4, wobei die korrosionsschützende Beschichtung eine Dicke von 0,1 bis 100 µm, bevorzugt von 1 bis 50 µm, bevorzugter von 5 bis 25 µm und besonders bevorzugt von 7 bis 20 µm aufweist.

6. Korrosionsschützende Beschichtung nach einem der Ansprüche 1-5, wobei die korrosionsschützende Beschichtung dazu geeignet ist, mittels eines Vakuumabscheideverfahrens auf ein Substrat aufgetragen zu werden.

7. Beschichteter Gegenstand, der zumindest teilweise aus einem Material hergestellt ist, und der zumindest teilweise mit der korrosionsschützenden Beschichtung nach einem der Ansprüche 1-6 beschichtet ist.

8. Beschichteter Gegenstand nach Anspruch 7, wobei das Material eisenhaltig ist.

9. Beschichteter Gegenstand nach Anspruch 7 oder 8, wobei das Material Stahl ist.

10. Beschichteter Gegenstand nach einem der Ansprüche 7-9, wobei das Substrat vollständig mit der korrosionsschützenden Beschichtung beschichtet ist.

11. Beschichteter Gegenstand nach einem der Ansprüche 6-10, wobei die korrosionsschützende Beschichtung mithilfe einer Sputtertechnik oder einem IVD (ion vapour deposition)-Verfahren aufgetragen ist.

12. Verfahren zum Herstellen eines beschichteten Gegenstands nach einem der Ansprüche 7-11, aufweisend die Schritte:
Bereitstellen eines Gegenstands, und
zumindest teilweises, bevorzugt vollständiges, Beschichten des Gegenstands mit der korrosionsschützenden Beschichtung nach einem der Ansprüche 1-6.

13. Verfahren nach Anspruch 12, wobei das Beschichten des Substrats mit der korrosionsschützenden Beschichtung mithilfe einer Sputtertechnik erfolgt, bevorzugt mithilfe einer Co-Sputtertechnik.

14. Verwendung einer Aluminiumlegierung, die 0,03 bis 0,5 Gewichts-% Zinn, bevorzugt 0,045-0,35 Gewichts-% Zinn, bevorzugter 0,1-0,3 Gewichts-% Zinn, noch bevorzugter 0,13-0,19 Gewichts-% Zinn und besonders bevorzugt 0,13-0,15 Gewichts-% Zinn umfasst, zum Herstellen einer Korrosionsschutzbeschichtung für einen eisenhaltigen Gegenstand.

15. Fahrzeug, bevorzugt Luftfahrzeug, umfassend eine korrosionsschützende Beschichtung nach einem der Ansprüche 1-6 oder einen beschichteten Gegenstand nach einem der Ansprüche 7-11.
